**Europäisches Patentamt**

**European Patent Office**

**Office européen des brevets**

(11) Veröffentlichungsnummer: **0 071 214**
**B1**

(12) # EUROPÄISCHE PATENTSCHRIFT

(45) Veröffentlichungstag der Patentschrift:
**29.10.86**

(21) Anmeldenummer: **82106685.9**

(22) Anmeldetag: **23.07.82**

(51) Int. Cl.⁴: **B 60 L 7/08, G 01 R 31/34**

(54) **Anordnung zur Ermittlung der Bremskräfte von Kommutatorfahrmotoren.**

(30) Priorität: **31.07.81 DE 3130368**

(43) Veröffentlichungstag der Anmeldung:
**09.02.83 Patentblatt 83/6**

(45) Bekanntmachung des Hinweises auf die Patenterteilung:
**29.10.86 Patentblatt 86/44**

(84) Benannte Vertragsstaaten:
**AT CH DE GB LI**

(56) Entgegenhaltungen:
**DE - A - 1 255 194**
**DE - A - 2 645 609**

**ELEKTRISCHE BAHNEN, Band 38, Nr. 11, November
1967, Seiten 255-262, München (DE); H.R. NEBELUNG et
al.: "Weiterentwicklung der elektrischen Bremse bei
den Lokomotiven E10/40 der Deutschen Bundesbahn".
ELEKTRISCHE BAHNEN, Band 38, Nr. 8, August 1967,
Seiten 176-179, München (DE); K. DREIMANN:
"Berechnung der Kennlinien für die fremderregte
Widerstandsbremse mit dem Analogrechner".**

(73) Patentinhaber: **Siemens Aktiengesellschaft Berlin und
München, Wittelsbacherplatz 2, D-8000 München 2 (DE)**

(72) Erfinder: **Kölmel, Kurt, Dr., Birkenallee 142,
D-8521 Bubenreuth (DE)**

## Beschreibung

Die Erfindung bezieht sich auf eine Anordnung zur Ermittlung der der Summe der elektrischen Bremskräfte mehrerer Kommutator-Fahrmotoren eines elektrischen Triebfahrzeuges, der im Oberbegriff des Anspruches 1 genannten Art.

Es ist bekannt, die elektrischen Bremskräfte von Lokomotiven mit Kommutatormaschinen durch Messungen der Bremswiderstands-Leistungen der Fahrantriebe und der Geschwindigkeiten der Lokomotive nach der Beziehung

$$F \approx \Sigma \frac{U_A \times J_A}{\upsilon}$$

zu ermitteln. Darin bedeuten: F die Bremskraft, $U_A$ die Ankerspannung, $J_A$ den Ankerstrom und $\upsilon$ die Geschwindigkeit. Diese Methode wird mit zum Teil mehreren Wattmetern im allgemeinen bei Neueinstellungen und Untersuchungen der elektrischen Bremsen benutzt. Nachteilig ist dabei der grosse personelle und messtechnische Aufwand, da alle Antriebe gleichzeitig in einem Bremsvorgang gemessen werden müssen. Ausserdem sind vor den Messbremsungen noch etwa zehn Vorbremsungen erforderlich, um einen eventuellen Bürstenkippeffekt (nach Fahrtrichtungswechsel vorübergehend durch Verlagerung der Bürstenauflage aus der neutralen Zone auftretende Bremskraftvergrösserung) abzubauen. Die Tatsache, dass die Bremskraftwerte erst nachträglich rechnerisch ermittelt werden müssen und dann die Kurve nur punktuell entsteht, ist besonders störend für den Arbeitsablauf.

Um diesen Aufwand zu verringern und den Verlauf der ganzen Bremskraftkurve kontinuierlich und sofort während des Bremsvorganges zu erhalten, hat man die Bremskraft auch über die Produktbildung von gemessenen Anker- und Erregerstromwerten ermittelt. In der Zeitschrift «Elektrische Bahnen», Heft 6, 1966, Seite 149 bis 151 ist eine solche Messeinrichtung gemäss dem Oberbegriff des Anspruchs 1 beschrieben, bei welcher in einem Hallwandler die Ankerstromwerte addiert und die Summe mit dem Erregerstromwert multipliziert wird. Die Hallspannung wird als Ergebnis für eine der Bremskraft verhältnisgleiche Grösse durch ein schreibendes Messgerät aufgezeichnet. Dabei wird davon ausgegangen, dass die Voraussetzung eines Bremsbetriebes im linearen Teil der Leerlauf-Magnetisierungskennlinie (ungesättigter Bereich) meist erfüllt sei. Der praktischen Anwendung dieses Verfahrens steht jedoch die geringere Genauigkeit gegenüber der Wattmeter-Methode entgegen.

Der Erfindung liegt die Aufgabe zugrunde, die elektrische Bremskraft von Lokomotiven unter Erzielung einer mindestens so guten Genauigkeit wie mit der bekannten Wattmeter-Methode, jedoch mit wesentlich kleinerem personellem und messtechnischem Aufwand und mit sofortiger Anzeige der Messwerte zu ermitteln. Diese Ermittlungen sind bei Neu- und Nacheinstellungen der elektrischen Bremseinrichtungen sowie bei allen Untersuchungen von elektrischen Bremsvorgängen von Lokomotiven unterschiedlicher Typen erforderlich.

Diese Aufgabe wird, ausgehend von der eingangs genannten Anordnung, erfindungsgemäss durch die im kennzeichnenden Teil des Anspruches 1 angegebenen Massnahmen gelöst.

Besondere Ausführungsformen sind in den Ansprüchen 2 bis 4 angegeben.

Als Fahrmotoren werden meist Maschinen verwendet, bei denen eine Rückwirkung des Ankerstromes auf den Magnetisierungsfluss durch Einsatz einer Kompensationswicklung ausgeglichen wird, um bei Leerlauf und Belastung dieselbe Magnetisierungskennlinie zu erreichen. Der Erfindung liegt die Überlegung zugrunde, dass jedoch auch bei kompensierter Maschine eine das Messergebnis quadratisch verfälschende, restliche Abweichung der Magnetisierungskennlinie zwischen Leerlauf und Bremsung auftritt. Derartige, das Messergebnis verfälschende Abweichungen werden bei der erfindungsgemässen Anordnung eliminiert, so dass im Gegensatz zu den bekannten Verfahren über die Produktbildung von Erregerstrom und Ankerstrom eine wesentlich höhere Genauigkeit erzielt wird.

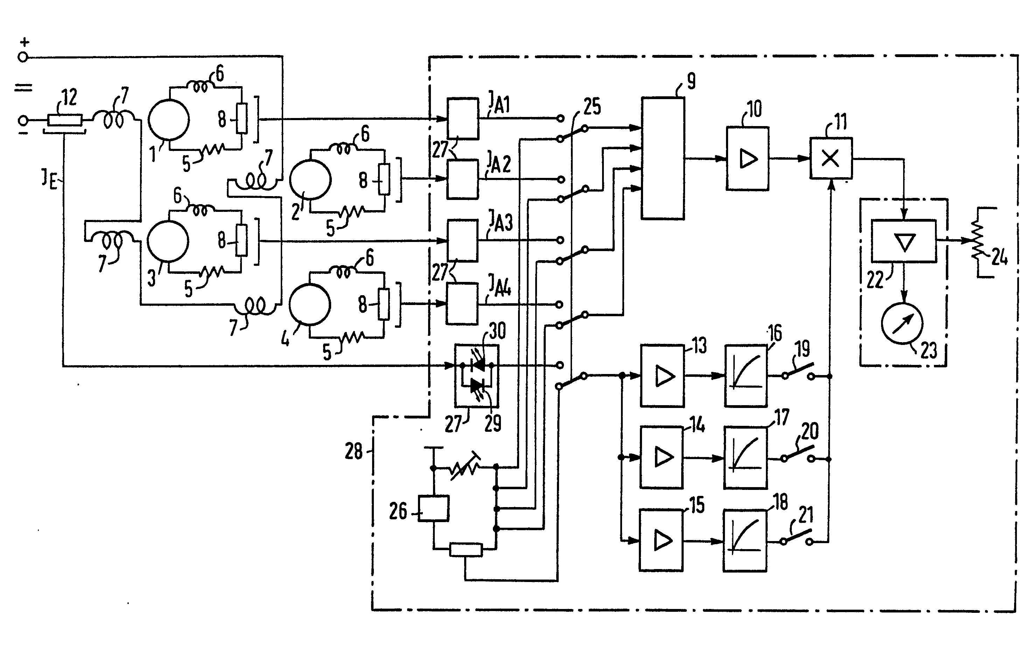

Ein Ausführungsbeispiel der Erfindung ist in der Zeichnung schematisch dargestellt. Die Figur zeigt ein Blockschaltbild einer Bremskraftmessanordnung.

Mit 1 bis 4 sind Fahrmotoren eines elektrischen Triebfahrzeuges bezeichnet, deren Anker jeweils auf einen Bremswiderstand 5 geschaltet sind. Zur Kompensation der Ankerrückwirkung dienen Kompensationswicklungen 6. Die Erregerwicklungen 7 der Fahrmotoren 1 bis 4 sind in Serie an eine Spannungsquelle gelegt. In den einzelnen Bremskreisen ist jeweils ein Shunt 8 zum Erfassen der Ankerströme $J_{A1}$ bis $J_{A4}$ angeordnet, die in einem Summierglied 9 addiert und über einen Verstärker 10 dem Eingang eines Multipliziergliedes 11 zugeführt werden. Summierglied 9 und Verstärker 10 können dabei ein einziges Bauelement bilden. Dem anderen Eingang des Multipliziergliedes wird ein vom Erregerstrom abhängiges Signal zugeführt. Ein in einem Shunt 12 erfasstes, dem Erregerstrom $J_E$ proportionales Signal wird mittels Schalter 19 bis 21 wahlweise über einen der Verstärker 13 bis 15 und einen der Funktionsgeneratoren 16 bis 18 geleitet. Je nachdem, um welchen Lokomotivtyp es sich handelt, wird einer der Schalter 19 bis 21 geschlossen.

In den Funktionsgeneratoren 16 bis 18 wird das Erregerstromsignal so modifiziert, dass es proportional dem tatsächlichen Verlauf des magnetischen Kraftflusses $\Phi$ der gleich aufgebauten Fahrmotoren 1 bis 4 bei der Bremsung entspricht.

In den Verstärkern 13 bis 15 werden dem Erregerstromsignal der Lokomotive typische Grössen eingeprägt, wie z.B. die Getriebeuntersetzung und lokspezifische Restanteile des Verhältnisses innerer Bremskraft $F_i$ zu äusserer Bremskraft $F_a$, die über den gemeinsamen Hauptanteil hinausgehen.

Bei der bisher bekannten Leistungsmessmethode wird die Leistung an den Bremswiderständen gemessen. Diese als innere Bremskraft $F_i$ bezeichnete Kraft wird allgemein allein bei der Einstellung und Untersuchung von elektrischen Bremsen betrachtet

$$(F_i \approx \Sigma \frac{U_A \times J_A}{\upsilon}).$$

Darüberhinaus existieren aber noch eine Reihe kleinerer Bremskraftanteile, die zum Teil aus den Fahrantrieben stammen. Diese und die innere Bremskraft $F_i$ setzen sich zusammen zur äusseren Bremskraft:

$$F \approx \Sigma \frac{EMK \times J_A}{\upsilon}$$

Darin bedeutet EMK die elektromotorische Kraft. Bei Einsatz der Produktbildung

$$\Sigma \, \Phi \times J_A$$

zur Messung erhält man immer ein Abbild dieser äusseren Bremskraft $F_A$.

Um die Messergebnisse der Anordnung vergleichsfähig mit bisherigen Bremskraftangaben und -messungen zu machen, kann deshalb das im Gerät entstandene Ergebnis um das Verhältnis $F_i/F_A$ reduziert werden. Dieses Verhältnis ist bei den einzelnen Lokomotivtypen verschieden gross. Der für alle Lokomotiven gemeinsame Hauptanteil des Verhältnisses $\frac{F_i}{F_a}$ kann im Verstärkungsgrad des Verstärkers 22 berücksichtigt werden.

Im Multiplikationsglied 11 wird ein Ausgangssignal gebildet, das proportional der Summe der inneren Bremskräfte $F_i$ der vier Fahrmotoren ist. In dem dem Multiplikationsglied nachgeschalteten Verstärker 22 wird das Signal für die Anzeige der Bremskraft durch ein als Voltmeter ausgebildetes Messgerät 23 angepasst und der Verstärkungsgrad um den gemeinsamen Hauptanteil von $\frac{F_i}{F_a}$ reduziert.

Da die Messergebnisse für die Bremskraft auf den Schienen vom Abnützungsgrad der Reifen abhängen, wird der Radreifendurchmesser durch Änderung der Verstärkung des Verstärkers 22 über ein Potentiometer 24 berücksichtigt.

Um einen hohen Sicherheitsgrad der als tragbares Gerät 28 ausgebildeten Messanordnung zu gewährleisten, sind Prüfeinrichtungen eingebaut. Vor der Messung kann man das Gerät 28 auf Funktionssicherheit bezüglich der exakten Verarbeitung der Messgrössen vom Eingang bis zur Ausgabe kontrollieren. Dadurch werden möglicherweise falsche elektrische Bremskrafteinstellungen bei eventuell defektem Gerät vermieden. Hierzu wird der Messeingang über einen Umschalter 25 mit einer Konstantspannungsquelle 26 (feste Referenzspannung) verbunden. Dadurch werden dem Gerät 28 Shunt-Ersatzspannungen in geeigneter Höhe angeboten, so dass bei richtiger Funktion ein bestimmter Bremskraftwert in der Anzeige des Messgerätes 23 erscheint. Eine Abweichung von diesem Wert signalisiert eine Störung im Gerät 28.

Die Anschlussschaltung des Gerätes 28 besteht aus bis zu zehn Anschlüssen von den Shunts 8 und 12 der Anker- und Erregerstromkreise.

Durch Verwechslung von Anschlüssen können Falschmessungen entstehen, wodurch möglicherweise auch falsche Bremskrafteinstellungen vorgenommen werden. Um dies zu vermeiden, wird die Richtigkeit der Polaritäten über eine Abfrageschaltung 27 an grünen Leuchtdioden 29 und roten Leuchtdioden 30 auf der Frontseite des Gerätes angezeigt.

Das Messgerät 23 zeigt mit Hilfe des Einsatzes der Lastflusskurvenfunktion die Summe aller Fahrmotor-Bremskräfte eines Drehgestelles oder der ganzen Lokomotive in kN an, wie sie aus der Summe der Bremswiderstandsleistungen entstehen würde. Die Bremskraftkurve kann in vorteilhafter Weise auch mit einem Schreiber aufgenommen werden.

Gegenüber der bekannten Vier-Wattmeter-Methode ist für die Messungen anstelle von fünf Personen nur noch eine Person erforderlich. Da das Gerät den Bürstenkippeffekt nicht registriert, sind die zum Abbau eines solchen bei der Wattmeter-Methode erforderlichen zehn Vorbremsungen überflüssig. Dadurch wird die Gesamtzahl der Bremsungen von etwa 13 auf 3 reduziert. Die nachträgliche Auswertung der Wattmeterablesungen entfällt, da die Anzeige sofort erscheint bzw. ein Schreiber die ganze Bremskraftkurve kontinuierlich aufzeichnet. Die Messanordnung ist als tragbares Gerät angepasst und durch die umschaltbaren Funktionsgeneratoren auf verschiedene Lokomotivtypen weitgehend universell einsetzbar. Die Sicherheitseinrichtungen schützen vor Falschmessungen und falscher Bremskrafteinstellung, soweit es die vergleichende Messung betrifft.

Bezugszeichenliste
1–4 Fahrmotoren
5 Bremswiderstand
6 Kompensationswicklung
7 Erregerwicklung
8 Shunt
9 Summierglied
10 Verstärker
11 Multiplizierglied
12 Shunt
13 Verstärker
14 Verstärker
15 Verstärker
16 Funktionsgenerator
17 Funktionsgenerator
18 Funktionsgenerator
19 Schalter
20 Schalter
21 Schalter
22 Verstärker
23 Messgerät
24 Potentiometer
25 Umschalter

26 Spannungsquelle
27 Abfrageschaltung
28 tragbares Gerät
29 grüne Leuchtdiode
30 rote Leuchtdiode
$J_{A1}$–$J_{A4}$  Ankerströme
$J_E$  Erregerstrom
$F_i$  innere Bremskraft
$F_a$  äussere Bremskraft

**Patentansprüche**

1. Anordnung zur Ermittlung der Summe der elektrischen Bremskräfte mehrerer Kommutator-Fahrmotoren (1–4) eines elektrischen Triebfahrzeuges, bei der die Bremskraft durch Multiplikation zweiter Messwerte gebildet wird, von denen der erste eine der Summe der Ankerströme und der zweite eine dem Erregerstrom entsprechende Grösse ist, dadurch gekennzeichnet, dass die dem Erregerstrom ($J_E$) entsprechende Grösse so modifiziert wird, dass sie dem tatsächlichen Verlauf des magnetischen Motorkraftflusses ($\Phi$) bei Bremsung entspricht, indem jeweils einer von mehreren Funktionsgeneratoren (16, 17, 18) über Schalter (19, 20, 21) zugeschaltet wird, wobei jeder Funktionsgenerator jeweils an einen von mehreren Triebfahrzeugtypen angepasst ist.

2. Anordnung nach Anspruch 1, dadurch gekennzeichnet, dass der dem Erregerstrom ($J_E$) entsprechenden Grösse lokomotivtypische Grössen, wie Getriebeuntersetzung, eingeprägt werden.

3. Anordnung nach Anspruch 1 oder 2 für ein Triebfahrzeug mit Widerstandsbremse, dadurch gekennzeichnet, dass die dem Erregerstrom entsprechende Grösse mit einem Faktor multipliziert wird, der dem Verhältnis der Leistung im Bremswiderstand zur Leisutng des gesamten elektrischen Ankerstromkreises entspricht.

4. Anordnung nach einem der vorhergehenden Ansprüche, dadurch gekennzeichnet, dass die Messwerteingänge für die Ankerströme ($J_{A1}$–$J_{A4}$) und den Erregerstrom ($J_E$) über einen Umschalter (25) auf eine Konstantspannungsquelle (26) schaltbar sind.

**Claims**

1. An arrangement for determining the sum of electrical braking forces for a plurality of commutator traction motors (1–4) in an electrically driven vehicle, wherein the braking force is formed by the multiplication of two measured values, the first of which is a sum of the armature currents, and the second of which is a magnitude related to the excitation current, characterised in that the magnitude related to the excitation current is modified such that it corresponds to the actual course of the magnetic motor flux ($\Phi$) during braking, in that each one of several function generators (16, 17, 18) is selectively connected by means of switches (19, 20, 21), where each function generator is respectively adapted to one of a plurality of types of driving vehicle.

2. An arrangement as claimed in Claim 1, characterised in that the magnitude corresponding to the excitation current ($J_E$) is impressed with typical locomotive magnitudes, such as gear reduction.

3. An arrangement as claimed in Claim 1 or 2, for a driving vehicle with resistance brake, characterised in that the magnitude corresponding to the excitation current is multiplied by a factor which corresponds to the ratio of the power in the braking resistance to the power of the overall electrical armature circuit.

4. An arrangement as claimed in one of the preceding Claims, characterised in that the measured value inputs for the armature currents ($J_{A1}$–$J_{A4}$) and the excitation current ($J_E$) can be switched to a constant voltage source (26) by a change-over switch (25).

**Revendications**

1. Dispositif pour déterminer la somme des forces électriques de freinage de plusieurs moteurs de traction à commutateurs (1, 4) d'un véhicule électrique de traction, dans lequel la force de freinage est formée par le produit de deux valeurs de mesure dont la première est la somme des courants d'induits et la seconde est une grandeur qui correspond au courant d'excitation, caractérisé par le fait que la grandeur qui correspond au courant d'excitation ($J_E$) est modifiée de telle façon qu'elle corresponde à l'allure effective du flux de forces magnétiques du moteur ($\Phi$) au freinage par branchement de l'un parmi plusieurs générateurs de fonctions (16, 17, 18) à l'aide d'interrupteurs, chacun des générateurs de fonctions étant adaptés à l'un parmi plusieurs types des véhicules de traction.

2. Dispositif selon la revendication 1, caractérisé par le fait qu'à la grandeur qui correspond au courant d'excitation ($J_E$) on imprime des grandeurs caractéristiques de la locomotive, par exemple la démultiplication de la transmission.

3. Dispositif selon la revendication 1 ou 2, pour un véhicule électrique de traction à frein rhéostatique, caractérisé par le fait que la grandeur qui correspond au courant d'excitation est multipliée par un facteur qui correspond au rapport entre la puissance dans la résistance de freinage et la puissance de la totalité du circuit électrique du courant d'induit.

4. Dispositif selon l'une des revendications précédentes, caractérisé par le fait que les entrées des valeurs de mesure pour les courants d'induits ($J_{A1}$, $J_{A4}$) et du courant d'excitation ($J_E$) sont susceptibles d'être commutées, à l'aide d'un commutateur (25), sur une source de tension constante (26).